(19) Europäisches Patentamt / European Patent Office / Office européen des brevets

(11) **EP 2 626 711 B1**

(12) **FASCICULE DE BREVET EUROPEEN**

(45) Date de publication et mention de la délivrance du brevet:
**11.03.2015 Bulletin 2015/11**

(51) Int Cl.:
***G01R 15/24*** *(2006.01)*

(21) Numéro de dépôt: **12154889.5**

(22) Date de dépôt: **10.02.2012**

(54) **Dispositif de mesure de courant HVDC à large bande passante, très haute précision**

Messvorrichtung für HVDC-Strom mit großer Bandbreite und sehr hoher Präzision

High-bandwidth, very-high-precision device for measuring HVDC current

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**14.08.2013 Bulletin 2013/33**

(73) Titulaire: **ALSTOM Technology Ltd**
**5400 Baden (CH)**

(72) Inventeurs:
• **Chatrefou, Denis**
**13320 BOUC BEL AIR (FR)**
• **Mironneau, Jean-François**
**69003 LYON (FR)**
• **Jung, Thierry**
**69002 LYON (FR)**
• **Bordes, Julien**
**69001 LYON (FR)**

(74) Mandataire: **Augarde, Eric**
**Brevalex**
**56, boulevard de l'Embouchure**
**B.P. 27519**
**31075 Toulouse Cedex 2 (FR)**

(56) Documents cités:
• **D. Chatrefou: "NCIT's - Modern digital instruments transformers for UHV AC and DC networks", Conference on Advances in Power System Control, Operation and Management (APSCOM 2009), 8th International, 29 juillet 2010 (2010-07-29), pages 1-6, XP55034959, DOI: 10.1049/cp.2009.1814 Extrait de l'Internet: URL: http://ieeexplore.ieee.org/ielx5/55100 85/5526322/05528921.pdf?tp=&arnumber=55289 21&isnumber=5526322 [extrait le 2012-08-08]**
• **KRAMER S G M ET AL: "Integration of a Distributed Fiber Optic Current Sensor Setup for Lightning Detection in Wind Turbines", INSTRUMENTATION AND MEASUREMENT TECHNOLOGY CONFERENCE PROCEEDINGS, 2007 IEEE, IEEE, PI, 1 mai 2007 (2007-05-01), pages 1-5, XP031182367, DOI: 10.1109/IMTC. 2007.379440 ISBN: 978-1-4244-0588-6**
• **KUCUKSARI S ET AL: "Experimental Comparison of Conventional and Optical Current Transformers", IEEE TRANSACTIONS ON POWER DELIVERY, IEEE SERVICE CENTER, NEW YORK, NY, US, vol. 25, no. 4, 1 octobre 2010 (2010-10-01), pages 2455-2463, XP011317105, ISSN: 0885-8977**

**Description**

**DOMAINE TECHNIQUE**

L'invention se situe dans le domaine de la transmission de l'énergie électrique à très haute tension en courant continu. Elle porte plus particulièrement sur un dispositif capable de mesurer le courant électrique DC dans une station Haute Tension, en sortie d'un convertisseur à découpage.

**ÉTAT DE LA TECHNIQUE ANTÉRIEURE**

Les sous-stations HVDC (High Voltage Direct Current) modernes, comme les sous-stations AIS (Air Insulated Station) et GIS (Gas insulated Station), nécessitent des étages de convertisseurs commandés avec des fréquences de commutation importantes, une dynamique rapide et des tensions de l'ordre de 800 kV.

Le spectre du courant en sortie du (ou des) convertisseur(s) de type redresseur comporte, en plus de la composante à fréquence nulle (composante DC), des harmoniques résiduelles (composantes AC) à des fréquences allant jusqu'à quelques kHz.

La connaissance de la valeur du signal du courant « complet ou composite » (c'est-à-dire du DC jusqu'à la plus haute fréquence AC) est nécessaire afin d'estimer la qualité du redressement effectué ainsi que pour mettre en oeuvre une modulation de largeur d'impulsion (PWM pour Pulse Width Modulation) pour la commande du découpage. Dans ce cas, la connaissance précise de la valeur du courant permet de régler les paramètres de modulation de manière optimale en vue de bloquer ou de mettre en saturation, au moment opportun, les commutateurs à semi-conducteur (type MOSFET, IGBT, thyristors) des convertisseurs.

Dans ce but, des capteurs de courant spécifiques aux applications HVDC sont intégrés dans les sous-stations. Le capteur de courant HVDC doit avoir les propriétés suivantes

- large bande passante pour mesurer le signal du courant « complet ou composite », afin de fournir une réponse rapide aux ondulations résiduelles et transitoires du courant ;

- stabilité de la mesure ;

- absence de limitation en tension ;

- mesures non affectées par les paramètres environnementaux (température...).

Les capteurs de courant sont majoritairement de deux sortes : les capteurs dits « flux zéro » (ou flux nul) qui utilisent l'effet Hall et des systèmes asservis, et les capteurs magnéto-optiques qui utilisent l'effet Faraday.

Dans la suite de la description, on appellera capteurs Faraday les capteurs magnéto-optiques qui utilisent l'effet Faraday.

Les capteurs flux zéro utilisent le principe de l'effet Hall pour mesurer une tension proportionnelle à l'intensité du courant grâce à des tores secondaires de mesure, isolées de la barre primaire dans laquelle circule le courant. Une électronique de contre-réaction permet d'annuler le flux magnétique continu et donc d'éviter la saturation des noyaux magnétiques.

De tels capteurs sont capables de mesurer des formes d'onde de courants, alternatifs et complexes tout en assurant une isolation galvanique. Par ailleurs, ils présentent l'avantage d'avoir une large bande passante, du DC jusqu'à quelques dizaines de kHz.

En courant continu, la mesure du courant par des capteurs de type « flux zéro » est cependant limitée à 500kV, car au-delà, l'isolation entre le primaire et le secondaire est prohibitive en terme de coût, de poids et d'encombrement. De surcroît, des effets magnétiques non maîtrisés peuvent rendre le capteur instable thermiquement et potentiellement dangereux. En effet, l'isolation entre le primaire et le secondaire, utilise des liquides ou des gaz sous pression pouvant exploser ou brûler.

Le capteur Faraday utilise le fait qu'un champ magnétique B induit une biréfringence circulaire dans un guide d'onde optique. Ce guide d'onde est réalisé en un matériau diamagnétique ou paramagnétique isotrope non absorbant.

Dans un tel guide d'onde, une onde polarisée circulaire gauche a une vitesse de propagation différente d'une onde polarisée circulaire droite. Si une onde polarisée linéairement traverse le guide d'onde, son plan de polarisation subit une rotation d'un angle $\varphi$, donnée par :

$$\varphi(t) = \frac{V}{\mu_0} \int B(t).dx \qquad\qquad (1)$$

où V est la constante de Verdet du guide d'onde, dont la valeur dépend du matériau, de la température, ainsi que de la longueur d'onde de l'onde polarisée qui s'y propage ;
et $\mu_0$ est la perméabilité du vide ;
x la longueur du chemin optique dans le guide d'onde.

De manière générale, les matériaux potentiels pour former le guide d'onde optique d'un capteur Faraday sont choisis parmi ceux qui présentent notamment une constante de Verdet élevée pour la longueur d'onde de l'onde lumineuse polarisée linéairement qui traverse le guide d'onde.

Dans un capteur Faraday, le guide d'onde optique entoure un conducteur électrique parcouru par le courant $I_{LB}$ à mesurer. L'application du théorème d'Ampère permet de relier le champ B(t) au courant $I_{LB}$ :

$$\varphi(t) = V.I_{LB}.k \qquad\qquad (2)$$

avec $I_{LB} = I_{DC} + I_{AC}(t)$

$I_{DC}$ et $I_{AC}$ étant respectivement les composantes continue et alternative du courant et $k$ est une constante qui dépend du guide d'onde optique utilisé.

Le guide d'onde optique peut notamment être une fibre optique agencée en boucle fermée entourant le conducteur électrique dans lequel circule le courant $I_{LB}$, comme décrit dans la demande publiée WO 2010/012300 A1 ou un milieu transparent (capteur de type « Ring-Glass ») muni d'un trou central traversé par le conducteur et usiné de manière à ce que la lumière décrive, par une série de réflexions totales à 45°, un contour fermé. Un capteur de type Ring-Glass est par exemple exposé dans le brevet FR 93 01991.

Les capteurs de type Ring-Glass présentent notamment l'avantage d'être moins volumineux pour la mesure des forts courants et permettent d'utiliser une technique d'analyse par polarimétrie. En effet dans le cas des capteurs à fibre optique et pour de forts courants, le bobinage de la fibre optique doit se faire sur une longueur importante du conducteur et les imperfections intrinsèques de la fibre limitent fortement la sensibilité de la mesure dans le cas d'une analyse par polarimétrie.

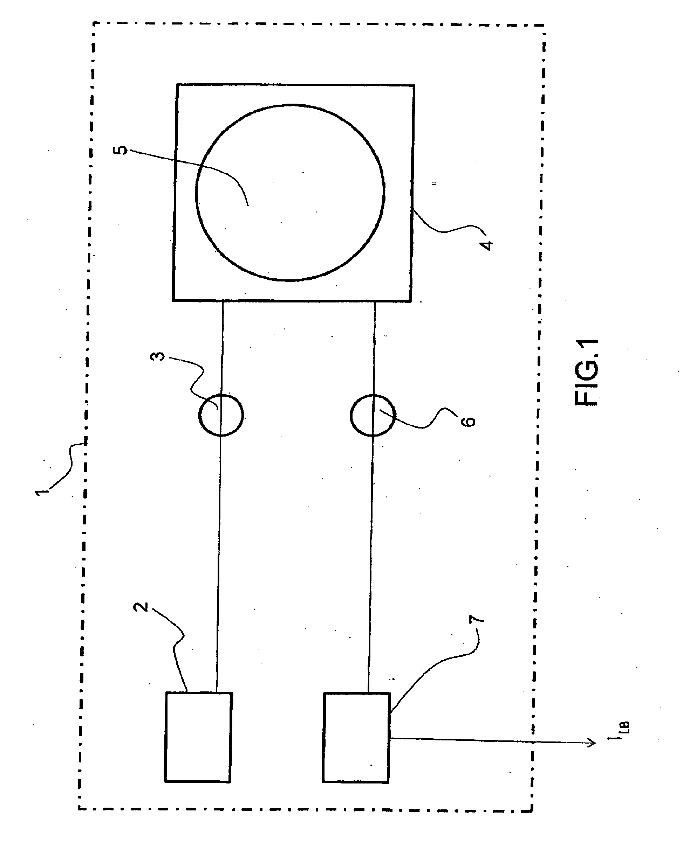

Le capteur Faraday mesure l'angle de rotation φ pour en déduire le courant $I_{LB}$. La figure 1 illustre le synoptique d'un capteur Faraday connu de l'état de la technique.

La figure 1 représente, de manière non limitative, les éléments essentiels d'un capteur Faraday.

Le capteur Faraday 1 comporte une source de lumière 2 qui émet une lumière monochromatique. La lumière émise par la source 2 est polarisée linéairement au moyen d'un polariseur d'entrée 3. L'onde lumineuse polarisée linéairement traverse ensuite le guide d'onde 4 entourant le conducteur 5 dans lequel circule le courant $I_{LB}$ à mesurer. En sortie du guide d'onde 4, l'onde lumineuse traverse un analyseur 6 dont l'axe de polarisation est décalé d'un angle θ par rapport à l'axe de polarisation du polariseur d'entrée 3. L'analyseur 6 décompose l'onde optique sur deux axes de références orthogonaux de façon à obtenir deux signaux optiques. Un détecteur optique 7 situé en sortie de l'analyseur 6 comprend des moyens de photodétection qui mesurent l'intensité lumineuse d'au moins un des deux signaux optiques reçus en sortie de l'analyseur 6. Les moyens de calcul du détecteur 7 calculent l'angle φ à partir de l'intensité du au moins un signal détecté et produisent un signal de tension $V_{OUT}$ qui est une fonction du courant $I_{LB}$ à mesurer.

La liaison optique entre la source lumineuse 2 et le polariseur 3, le polariseur 3 et le guide optique 4, le guide optique 4 et l'analyseur 6 et l'analyseur 6 et le détecteur 7 est réalisée au moyen de fibres optiques.

En sortie de l'analyseur et en présence d'un courant $I_{LB}$ circulant dans le conducteur 5, les intensités A(t) et A' (t) des deux signaux optiques reçus par les moyens de photodétection du détecteur optique 7 sont données par la loi de Malus :

$$A(t) = a(t).sin^2\big(\theta + \varphi(t)\big) \quad et \quad A'(t) = a(t).cos^2\big(\theta + \varphi(t)\big) \quad (3)$$

où $a(t)$ est un coefficient variable qui traduit la dépendance des intensités lumineuses A(t) et A'(t) à la puissance de la source lumineuse 2, aux couplages des connecteurs optiques, aux imperfections des transmissions des câbles optiques ainsi que des couplages avec le capteur Faraday.

De manière générale, θ est choisi de sorte que $\theta = \frac{\pi}{4}$ ou $\frac{\pi}{2}$. Si l'on développe l'équation donnant l'intensité lumineuse du premier signal optique pour $\theta = \frac{\pi}{4}$, on obtient :

$$A(t) = \frac{a(t)}{2} + \frac{a(t)}{2}.\sin(2.k.V.I_{LB}(t)) \qquad (4)$$

Le signal de tension, noté S, issu des moyens de photodétection qui détectent le premier signal, est alors :

$$S(t) = \frac{a'(t)}{2} + \frac{a'(t)}{2}.\sin(2.k.V.I_{LB}(t)) \qquad (5)$$

avec $a' = \varepsilon.a$ et $\varepsilon$ est une constante relative à la sensibilité des composants électroniques du détecteur 7.

Afin d'expliciter certaines imprécisions de mesure des capteurs Faraday, on va considérer que l'angle $2.k.V.I_{LB}(t)$ est faible. L'expression précédente devient alors :

$$S(t) = \frac{a'(t)}{2} + a'(t).k.V.I_{LB}(t) \qquad (6)$$

Un développement de la relation 5 montre que le signal de tension $V_{OUT}$ en sortie du capteur Faraday 1 peut s'écrire alors comme la somme d'une composante continue et d'une composante alternative:

$$V_{OUT} = S = V_{DC-Faraday} + V_{AC-Faraday}(t) \qquad (7)$$

avec:

$$V_{DC-Faraday} = a'(t)\left(\frac{1}{2} + k.V.I_{DC}\right)$$

$$V_{AC-Faraday}(t) = a'(t)(k.V.I_{AC}(t))$$

Le facteur a' (t) est appelé coefficient du capteur Faraday.

Les capteurs Faraday sont remarquables en ce qu'ils répondent à la majorité des besoins exprimés plus haut. En effet, ils présentent l'avantage d'avoir un coût moindre que celui des capteurs à flux zéro, une bonne stabilité en température (pour ceux de dernière génération) ainsi qu'une large bande passante qui rend possible l'observation des harmoniques et des transitoires.

Cependant, les capteurs Faraday souffrent d'un défaut de stabilité de la mesure. En effet, de l'expression (7), on comprend que la tension $V_{OUT}$ en sortie du détecteur 7, relative à la mesure du courant $I_{LB}$, dépend de la valeur a' (t).

a' (t) est déterminé pour le capteur Faraday lors de son calibrage. Ainsi idéalement, la relation (7) est vérifiée et la précision du capteur Faraday est excellente.

or, a' (t) traduit la dépendance des mesures issues du capteur Faraday à des éléments qui peuvent se dégrader avec le temps ou dont la sensibilité ou le comportement peuvent varier durant la mesure. a' (t) peut donc varier et présenter une dérive $\delta a'$, de valeur inconnue, qui affecte la précision du capteur Faraday, puisque la relation (7) entre $V_{OUT}$ et $I_{Lb}$ devient alors :

$$V_{OUT} = \left(1 + \frac{\delta a'}{a'}\right) \cdot \left(V_{DC-Faraday} + V_{AC-Faraday}(t)\right) \qquad (8)$$

Une méthode simple afin de connaître la dérive $\delta a'$ et de corriger l'offset est de calibrer fréquemment le capteur Faraday. Une telle calibration est à proscrire car très coûteuse. En effet, cela implique d'arrêter la sous-station à chaque opération de calibration.

Des traitements, comme ceux décrits dans le document « Development of Bulk-Optic Current Sensor Using Glass Ring Type Faraday Cells », Tadashi SATO et Isamu SONE ou dans le brevet publié US 6,114,846 peuvent être mis en oeuvre afin de supprimer une partie de la dérive du coefficient a' du capteur Faraday sur le signal $V_{OUT}$ en sortie du capteur Faraday.

Ces traitements consistent à effectuer des traitements mathématiques sur deux signaux de tension issus des moyens de photodétection du détecteur 7 lorsque les deux signaux optiques en sortie de l'analyseur 6 sont pris en compte. Ces traitements ne sont cependant pas appropriés pour des mesures d'un courant $I_{LB}$ large bande avec une composante DC et plusieurs composantes spectrales.

L'objectif de la présente invention est de proposer un dispositif de mesure de courant dans un conducteur à haute tension, qui permette d'obtenir une mesure du signal du courant « complet ou composite » très précise.

Le document suivant divulgue les caractéristiques techniques qui sont définies dans le préambule de la revendication 1 : D. Chatrefou "NCIT's - Modern digital instruments transformers for UHV AC and DC networks", Conférence on Advances in Power System Control, Operation and Management (APSCOM 2009), 8th International, 29 juillet 2010 (2010-07-29), pages 1-6, DOI: 10.1049/cp.2009.1814.

**EXPOSÉ DE L'INVENTION**

Cet objectif est atteint par la présente invention qui est définie par un dispositif de mesure de courant selon la revendication 1.

Les moyens de calculs sont adaptés à calculer le courant à partir des équations (16) et (17) définies dans la suite de la description.

Avantageusement, la première composante DC dudit premier signal numérique et ladite seconde composante DC dudit second signal numérique sont obtenues par filtrage numérique desdits premier et second signaux numériques dans une bande de fréquence de 0 à 0,1 Hz.

Le second signal numérique peut-être obtenu en sortie d'une carte primaire opto-alimentée, ladite carte primaire étant installée dans une zone de haute tension comprenant le conducteur, le shunt de mesure et le guide d'onde optique.

De préférence, le capteur Faraday est du type Ring-Glass et le shunt est de classe de précision inférieure ou égale à 0,1.

Avantageusement, le shunt est réalisé en manganin.

Dans un mode de réalisation préféré de l'invention, le détecteur optique dudit capteur Faraday et lesdits moyens de calcul sont rapportés sur la même carte électronique, ladite carte électronique étant mise au potentiel de la terre et isolée dudit conducteur et comprend en outre la source lumineuse monochromatique dudit capteur Faraday pour transmettre un signal lumineux polarisé linéairement au moyen d'un polariseur audit guide d'onde optique via une fibre optique, la liaison entre ladite carte électronique et ladite carte primaire et la liaison entre ledit détecteur optique et ledit guide d'onde étant réalisée via des fibres optiques.

L'isolement de la carte électronique du conducteur est de préférence réalisé par un isolateur composite en résine silicone.

L'invention concerne également, une sous-station HVDC comprenant :

- au moins un convertisseur pour la conversion d'une tension AC en une tension DC, ledit convertisseur étant compris dans une enceinte délimitant la sous-station ;
- une traverse de mur pour connecter ledit au moins un convertisseur à des systèmes électriques situés en dehors de l'enceinte ;

ladite sous-station étant **caractérisée en ce qu'**elle comprend au moins un dispositif de mesure de courant selon l'invention, ledit dispositif étant installé sur un conducteur de courant qui relie ledit au moins un convertisseur à une extrémité de ladite traverse de mur située à l'intérieur de ladite enceinte.

La sous-station HVDC selon l'invention peut comprendre une pluralité de dispositifs selon l'invention, installés à la suite sur ledit conducteur de courant, au moins deux dispositifs ayant un shunt de mesure de haute précision en commun.

## BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles :

- la figure 1 illustre un synoptique d'un capteur magnéto-optique de courant à effet Faraday connu de l'état de la technique ;
- la figure 2 illustre le synoptique du traitement électronique des signaux numériques issus du capteur optique et du shunt de mesure, effectué par les moyens de calcul selon l'invention ;
- la figure 3 illustre un schéma du dispositif de mesure de courant selon un mode de réalisation préféré de l'invention.

## EXPOSÉ DÉTAILLÉ DE MODES DE RÉALISATION PARTICULIERS

L'idée à la base de l'invention est d'associer un capteur passif et un capteur actif, montés le long d'un conducteur dans lequel circule le courant $I_{LB}$ à mesurer. Le capteur passif est un shunt de mesure de haute précision et de grande stabilité directement installé sur le conducteur et le capteur actif est un capteur Faraday, dont le guide d'onde optique est directement installé sur le conducteur.

Le capteur Faraday peut être du type à fibre optique ou du type Ring Glass. Le synoptique du capteur Faraday est décrit en relation avec la figure 1. On suppose ici que le signal de tension en sortie du capteur Faraday, noté plus haut $V_{OUT}$, est un signal numérique.

L'homme du métier saura adapter et modifier les éléments décrits précédemment et constituant le capteur Faraday en fonction de la nature du guide d'onde optique employé.

Par shunt de mesure, on entend un shunt résistif associé à un dispositif de type voltmètre, mis en parallèle sur le shunt résistif, afin de fournir une tension analogique proportionnelle au courant $I_{LB}$.

Avantageusement, le signal analogique issu du shunt de mesure est numérisé au moyen d'un convertisseur analogique-numérique afin de simplifier l'intégration du shunt de mesure dans un réseau de capteurs.

Le capteur Faraday est utilisé pour la mesure du courant circulant dans le conducteur, du DC (0 Hz) jusqu'à la plus haute fréquence à mesurer. Le shunt de mesure est utilisé quant à lui pour mesurer avec une extrême précision et stabilité le courant DC. La complémentarité des deux capteurs permet d'obtenir un dispositif de mesure de courant HVDC à large bande passante et très haute précision. En régime permanent, l'erreur d'offset sur la mesure du courant effectuée par le capteur Faraday est corrigée par des moyens de calcul.

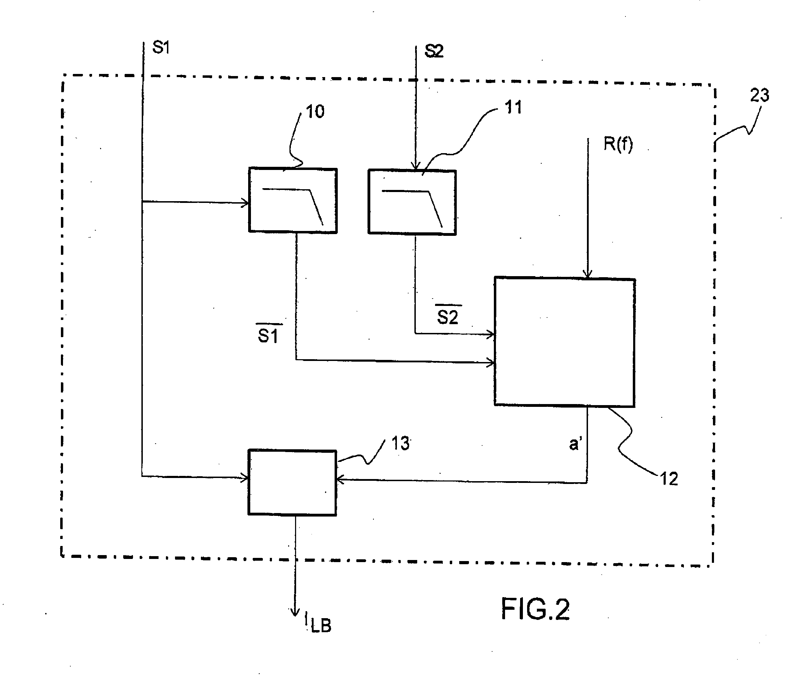

Plus précisément, la figure 2 illustre le synoptique de l'algorithme de traitement effectué par les moyens de calcul selon l'invention.

Les différentes étapes de l'algorithme mis en oeuvre au niveau des moyens de calcul 23 ont été représentées sous forme de modules, afin de faciliter la compréhension du traitement effectué.

Les moyens de calcul 23 réalisent une correction automatique des signaux de mesure issus du capteur actif au moyen de ceux issus du capteur passif.

Les moyens de calcul 23 reçoivent en entrée un premier signal numérique S1 et un second signal numérique S2 et ils fournissent en sortie une mesure précise du signal numérique $I_{LB}$.

Le premier signal S1 correspond au signal numérisé en sortie du détecteur du capteur Faraday dans le cas où seul l'un des deux signaux optiques a été détecté par les moyens de photodétection du détecteur. En reprenant la relation (6), on a alors :

$$S_1(t) = V_{OUT}(t) = V_{DC-Faraday} + V_{AC-Faraday}(t) \qquad (9)$$

Le premier signal est filtré par un module de filtrage passe-bas 10 de gain noté G(0.1f), qui filtre le signal dans une bande de fréquence de 0 à 0,1 Hz.

Le signal $\overline{S}_1$ en sortie du module de filtrage passe-bas 10 est donné par :

$$\overline{S}_1 = S_1 . G(0.1f) = a'(t_0)\left(\frac{1}{2} + k.V.I_{DC}\right) \qquad (10)$$

Le temps $t_0$ correspond au temps d'intégration du filtre de 0,1 Hz de bande passante et donc à la valeur précise de a' (t) au moment de ce filtrage. Dans la suite, cette valeur sera notée $a'_0$.

La composante continue du courant, obtenue par le capteur Faraday et notée $I_{DC-Faraday}$ est donnée par l'expression suivante :

$$I_{DC-Faraday} = \frac{\overline{S_1} - a'_0/2}{a'_0 . k . V} \qquad (11)$$

Le second signal numérique S2 est obtenu par numérisation de la tension analogique provenant du shunt de mesure. Il est donné par:

$$S_2(t) = R(f) . I_{LB}(t) \qquad (12)$$

où $R(f)$ est le ratio du shunt de mesure.

Le second signal est filtré par un module de filtrage passe-bas 11 de gain noté G(0.1f), identique au module de filtrage passe-bas 10, afin d'obtenir un signal $\overline{S}_2$ donné par :

$$\overline{S}_2 = S_2 . G(0.1f) = R(f) . I_{DC} \qquad (13)$$

A partir de $\overline{S}_2$, il est possible d'obtenir avec une grande précision la composante continue exacte $I_{DC}$ du courant. Au vu du gabarit du filtre utilisé, la classe de précision du capteur de courant continu $I_{DC}$ formé par l'association du shunt de mesure et du filtre est de 0,1. La composante $I_{DC}$ obtenue au moyen du shunt, notée $I_{DC-Shunt}$ est donnée par la relation suivante :

$$I_{DC-Shunt} = \overline{S}_2 . \frac{1}{R(f)} \qquad (14)$$

La valeur du ratio $R(f)$ du shunt de mesure est parfaitement constante dans la bande de fréquence de 0 à 0,1 Hz.

Le signal $I_{DC-shunt}$ donné par le shunt de mesure sert de référence pour la valeur de la composante continue du courant à mesurer.

Lorsque le coefficient du capteur Faraday *a'* n'a pas dérivé de sa valeur déterminée lors de la calibration, les deux signaux en sortie des modules de filtrage passe-bas 10 et 11 sont égaux, vérifiant de ce fait la relation: $I_{DC-Faraday}$ = $I_{DC-Shunt}$. Il convient donc de calculer le coefficient *a'* en permanence à partir des signaux reçus afin de vérifier cette égalité.

La valeur du coefficient *a'* du capteur Faraday est donnée par:

$$a' = \frac{2.\overline{S_1}.R(f)}{2.\overline{S_2}.k.V + R(f)} \qquad (15)$$

Il est alors possible en connaissant la valeur du coefficient *a'* du capteur Faraday d'obtenir une valeur extrêmement précise de la mesure du courant $I_{LB}$, à partir de l'équation (5), soit :

$$I_{LB} = \frac{1}{2.k.V}.Arcsin\left(\frac{2.S_1 - a'}{a'}\right) \qquad (16)$$

La méthode décrite ci-dessus permet également d'obtenir de manière simple la valeur du courant $I_{LB}$ à partir de l'équation (6), lorsque la valeur de la constante de Verdet est très faible. La mesure du courant, malgré l'approximation, n'en demeure pas moins précise et l'approximation effectuée permet de réduire la charge du calculateur. On a alors :

$$I_{LB} = \frac{1}{2.k.V}.\left(\frac{2.S_1 - a'}{a'}\right) \qquad (17)$$

L'algorithme mis en oeuvre par les moyens de calcul 23 permet de calculer la valeur précise du courant $I_{LB}$, de préférence par le calcul de l'expression (16). Une table de correspondance (table de look-up) pourra être utilisée pour le calcul de l'expression (16) afin de diminuer la charge des moyens de calcul 23. La valeur du courant $I_{LB}$ est obtenue grâce à deux modules des moyens de calcul 23.

Un premier module, dénommé module de calcul du coefficient de Faraday permet de calculer la valeur de *a'*, telle que donnée à l'expression (15). Le module de calcul du coefficient de Faraday 12 reçoit en entrée les signaux $\overline{S_1(t)}$ et $\overline{S_2(t)}$, ainsi que le ratio $R(f)$ du shunt de mesure.

Avantageusement, la valeur du ratio $R(f)$ est donnée par une table de correspondance.

Les valeurs de k et de V sont connues des moyens de calcul 23.

Le signal en sortie du module de calcul du coefficient de Faraday 12 est ensuite envoyé au second module, dénommé module de calcul 13 qui reçoit également en entrée le signal $S_1(t)$. Le module de calcul résout l'équation (16) ou l'équation (17), et en sortie de ce module 13, on obtient le signal numérique $I_{LB}$. Le traitement mis en oeuvre permet de corriger automatiquement toute erreur d'offset sur la mesure du courant par le capteur Faraday.

Le traitement effectué par les moyens de calcul 23 sur la valeur du courant donnée par le capteur Faraday est itératif et la valeur de *a'* est calculée en permanence et est stockée dans une mémoire.

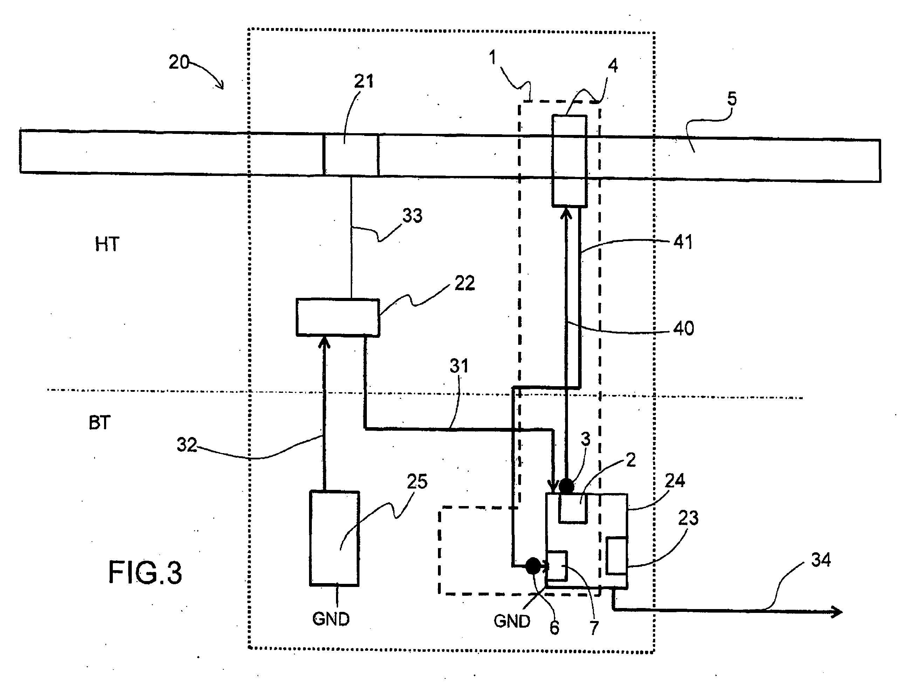

Dans la suite de la description, un mode de réalisation préféré du dispositif de mesure du courant selon l'invention va être décrit, en relation avec la figure 3.

Le dispositif de mesure de courant 20 comprend un shunt de mesure 21 et un capteur Faraday 1. Le guide optique 4 du capteur Faraday ainsi que le shunt de mesure 21 sont directement montés à la suite, le long du conducteur 5.

Les moyens de calcul 23 reçoivent en entrée le premier signal numérique $S_1$ et le second signal numérique $S_2$ et ils fournissent en sortie une mesure précise du signal numérique $I_{LB}$ qui peut alors être envoyée à des appareils électroniques de contrôle, via la liaison 34.

La numérisation du signal de tension analogique issu du shunt de mesure 21 en un signal numérique est assurée par une carte électronique primaire 22, de type CPHV3. Cette carte produit en sortie le second signal numérique

$S_2$, qui est transmis aux moyens de calcul 23 au moyen d'une fibre optique 31.

Le premier signal numérique $S_1$ provient, quant à lui, du détecteur optique 7 du capteur Faraday comme déjà indiqué plus haut.

Dans le mode de réalisation préféré de l'invention, le capteur Faraday est de type Ring-Glass, ce qui permet de simplifier la mise en oeuvre du dispositif 20. Le guide d'onde optique 4 est, dans ce cas, un milieu transparent muni d'un trou central traversé par le conducteur 5 et usiné de manière à ce que la lumière linéairement polarisée et entrant dans le guide d'onde décrive, par une série de réflexions totales à 45°, un contour fermé.

Le shunt de mesure 21 de courant DC utilisé est un shunt de haute précision et de haute stabilité. La classe du shunt est préférentiellement inférieure ou égale à 0,1. Il est prévu pour la mesure de courant DC de l'ordre de 800 kV ou au-delà.

On comprend que la classe de précision du shunt de mesure 21 détermine la classe de précision du dispositif 20. Ainsi, il est possible, en fonction du choix du shunt de mesure 21, d'obtenir un dispositif de mesure de courant 20 mesurant le courant à 800 kV, avec une classe de 0,1 et une large bande passante, et qui ne présente pas de limitation en tension.

Le shunt de mesure 21 est calibré pour ne pas provoquer d'augmentation en température qui serait préjudiciable à la qualité des mesures données par le capteur Faraday. On rappelle en effet que la constante de Verdet du guide d'onde optique 4 dépend de la température. Le shunt de mesure 21 est avantageusement constitué d'un matériau résistif de type alliage manganin, de grande stabilité thermique et présentant une très faible dérive, que l'on peut considérer comme déterministe et qui peut être corrigée électriquement.

Préférentiellement, le shunt de mesure 21 est choisi de telle sorte que le courant à mesurer dans le conducteur ne dépasse pas les 2/3 de son courant nominal, de préférence la moitié de celui-ci. L'augmentation de la température due au shunt de mesure 21 est alors négligeable si celui-ci est correctement calibré pour le courant à mesurer.

Afin de simplifier davantage la mise en oeuvre du dispositif 20 selon l'invention, le détecteur optique 7 du capteur Faraday est avantageusement rapporté sur une carte électronique 24, de type PC9-G3, sur laquelle sont rapportés également les moyens de calcul 23. Ainsi, la liaison entre les moyens de calcul 23 et le détecteur optique 7 est effectuée au moyen de pistes métalliques de cette carte

La liaison entre le guide d'onde optique 4 et l'analyseur 6 ainsi qu'entre l'analyseur 6 et le détecteur optique 7 est réalisée au moyen d'une fibre optique 41.

La carte électronique 24 contient également une DEL qui est la source lumineuse monochromatique 2 du capteur Faraday. Le faisceau lumineux issu de la DEL est transmis au polariseur 3 du capteur Faraday et au guide d'onde optique 4 via la fibre optique 40.

Le polariseur d'entrée 3 du capteur Faraday est de préférence placé au niveau de la source lumineuse 2 et l'analyseur 6 du capteur Faraday est avantageusement placé au niveau du détecteur optique 7.

La masse de la carte électronique 24 est avantageusement mise au potentiel de la terre GND. LA carte électronique est placée au sol lorsque le conducteur 5 est en hauteur. La liaison par fibre optique permet de placer la carte électronique 24 à une certaine distance de sécurité vis-à-vis du conducteur 5. On définit ainsi une zone haute tension HT, proche du conducteur 5, et une zone de basse tension BT au sol.

La carte primaire 22 est préférentiellement opto-alimentée. Dans ce cas, un convertisseur photoélectrique monté sur la carte primaire reçoit, au moyen d'une fibre optique 32, une énergie lumineuse émise par un laser 25 situé à distance de la carte primaire 22. Le laser 25 est situé dans la partie basse tension BT et généralement au sol lorsque le conducteur 5 est situé à une certaine hauteur.

En effet, en raison de sa liaison analogique 33 avec le shunt de mesure 21, la carte primaire 22 est située dans une zone proche du conducteur 5, c'est-à-dire la zone de haute tension HT, dangereuse dans le cas où des opérations de maintenance seraient nécessaires.

La zone haute tension HT contient le conducteur 5, la carte primaire 22, le shunt de mesure 21 et le guide d'onde optique 4 du capteur Faraday tandis que la zone basse tension BT contient les autres éléments du dispositif 20. Par conséquent, seule la zone basse tension BT contient les éléments susceptibles d'être affectés par une défaillance. L'isolement de la partie haute tension HT et la descente des fibres optiques est réalisé par un isolateur composite de type résine-silicone contenant les fibres optiques utiles. Cette isolation est peu coûteuse et ininflammable. Des visites d'entretien et de maintenance peuvent donc être effectuées à moindre risque dans la partie basse tension BT.

Les fibres optiques sont insensibles aux environnements hostiles et présentent une très faible conductivité thermique, contribuant de ce fait à la précision des mesures du dispositif 20.

Le dispositif 20 selon l'invention peut être mis en oeuvre pour des applications à des tensions inférieures à 800 kV, ou à 500 kV. L'encombrement limité du dispositif 20 lorsqu'il est réalisé selon le mode de réalisation préféré de l'invention, notamment en utilisant un capteur Faraday du type Ring-Glass, permet de réduire son coût d'installation et celui des matériaux utilisés, tout en garantissant une extrême précision.

Le dispositif selon l'invention est destiné à être intégré dans une sous-station HVDC.

La sous-station HVDC comprend au moins un convertisseur ou des étages de convertisseurs pour la conversion d'une tension AC en une tension DC. Ces convertisseurs sont situés dans l'enceinte de la sous-station HVDC.

Un dispositif du type traverse de mur (*wall bushing*) relie les convertisseurs à l'extérieur de la sous-station, pour connecter la sortie électrique des convertisseurs à des lignes hautes tension ou à des systèmes électriques situés en dehors de l'enceinte de la sous-station.

Un dispositif de mesure de courant selon l'invention est alors installé à l'intérieur de la sous-station sur un conducteur de courant qui relie les redresseurs à l'extrémité de la traverse de mur qui est située à l'intérieur de l'enceinte, afin de mesurer le courant en sortie de la sous-station.

L'encombrement réduit d'un dispositif réalisé selon le mode préféré de réalisation, permet d'installer une pluralité de dispositifs selon l'invention dans la sous-station HVDC à des fins de redondance électronique. Dans ce cas, les dispositifs peuvent être installés à la suite sur le conducteur de courant. On évite ainsi, en cas de défaillance d'un canal de mesure, de devoir interrompre le fonctionnement de la sous-station (outage), ce qui est extrêmement coûteux.

Il est cependant avantageux en terme de coût, de ne multiplier que les capteurs actifs et leur électronique associée. En effet, un capteur passif comme un shunt de mesure a un taux de défaillance proche de zéro. On peut ainsi mettre en oeuvre une pluralité de capteurs actifs partageant un même shunt de mesure et une même électronique associée au shunt de mesure.

D'autre part, le canal de mesure défaillant peut-être aisément réparé, sans interruption de la sous-station, grâce à l'isolation entre la partie basse tension de la partie haute-tension. Les éléments de la partie basse tension sont de préférence situés au sol comme déjà indiqué plus haut.

Le dispositif selon l'invention est adapté à des réseaux électriques dits « Smart Grid », dont la finalité est d'améliorer la qualité de service et la fiabilité des réseaux électriques.

**Revendications**

1. Dispositif de mesure de courant (20) pour mesurer le courant circulant dans un conducteur (5) à haute tension, ledit dispositif comprenant :

   - un capteur Faraday (1) comportant un guide d'onde optique (4) et un détecteur optique (7) relié au guide d'onde optique, ledit guide d'onde optique étant monté autour dudit conducteur, ledit capteur Faraday fournissant un premier signal numérique ($S_1$) représentatif de la valeur dudit courant ($I_{LS}$) et dont la valeur dépend d'un coefficient variable (a'), dit coefficient de Faraday, et
   - un shunt de mesure (21) monté en série sur ledit conducteur et fournissant un second signal numérique ($S_2$) représentatif de la valeur dudit courant et fonction d'un ratio ($R_f$) dudit shunt,
   **caractérisé en ce que** ledit dispositif comprend, en outre,
   - des moyens de calcul (23) recevant en entrée les deux signaux numériques et étant adaptés à extraire une première composante DC ($\overline{S}_1$) dudit premier signal numérique et une seconde composante DC ($\overline{S}_2$) dudit second signal numérique et à calculer la valeur dudit coefficient variable à partir de ladite première et de ladite seconde composantes DC et dudit ratio , lesdits moyens de calcul (23) étant adaptés à obtenir ledit courant à partir de la valeur ainsi calculée dudit coefficient de Faraday et dudit premier signal numérique.

2. Dispositif selon la revendication 1, caractérisé en ce les moyens de calculs (23) sont adaptés à calculer le courant à partir de l'équation :

$$I_{LB} = \frac{1}{2.k.V} \cdot Arcsin\left(\frac{2.S_1 - a'}{a'}\right)$$

où a' est le coefficient variable, *V* la constante de Verdet dudit capteur Faraday, k une constante dépendant du guide d'onde utilisé, $S_1$ ledit premier signal numérique et $I_{LB}$ ledit courant.

3. Dispositif selon la revendication 1, **caractérisé en ce que** les moyens de calculs (23) sont adaptés à calculer le courant à partir de l'équation :

$$I_{LB} = \frac{1}{2.k.V} \cdot \left(\frac{2.S_1 - a'}{a'}\right),$$

où a' est le coefficient variable, $V$ la constante de Verdet dudit capteur Faraday, k une constante dépendant du guide d'onde utilisé, $S_1$ ledit premier signal numérique et $I_{LB}$ ledit courant.

4. Dispositif selon l'une quelconque des revendications précédentes, **caractérisé en ce que** ladite première composante DC ($\overline{S}_1$) dudit premier signal numérique et ladite seconde composante DC ($\overline{S}_2$) dudit second signal numérique sont obtenues par filtrage numérique desdits premier ($S_1$) et second ($S_2$) signaux numériques dans une bande de fréquence de 0 à 0,1 Hz.

5. Dispositif selon l'une quelconque des revendications précédentes, **caractérisé en ce que** ledit second signal numérique ($S_2$) est obtenu en sortie d'une carte primaire (22) opto-alimentée, ladite carte primaire étant installée dans une zone de haute tension comprenant le conducteur, le shunt de mesure et le guide d'onde optique.

6. Dispositif selon l'une quelconque des revendications précédentes, **caractérisé en ce que** ledit capteur Faraday est du type Ring-Glass.

7. Dispositif selon l'une quelconque des revendications précédentes, **caractérisé en ce que** le shunt de mesure (21) est un shunt de classe de précision inférieure ou égale à 0,1.

8. Dispositif selon l'une quelconque des revendications précédentes, **caractérisé en ce que** le shunt est réalisé en manganin.

9. Dispositif selon l'une quelconque des revendications précédentes, **caractérisé en ce que** ledit détecteur optique (7) dudit capteur Faraday et lesdits moyens de calcul (23) sont rapportés sur la même carte électronique (24), ladite carte électronique étant mise au potentiel de la terre (GND) et isolée dudit conducteur (5) et comprend en outre la source lumineuse monochromatique (2) dudit capteur Faraday pour transmettre un signal lumineux polarisé linéairement au moyen d'un polariseur (3) audit guide d'onde optique (4) via une fibre optique (40), la liaison entre ladite carte électronique (24) et ladite carte primaire (22) et la liaison entre ledit détecteur optique (7) et ledit guide d'onde (4) étant réalisée via des fibres optiques (31,41).

10. Dispositif selon la revendication précédente, **caractérisé en ce que** l'isolement de la carte électronique (24) du conducteur (5) est réalisé par un isolateur composite en résine silicone.

11. Sous-station HVDC comprenant :

    - au moins un convertisseur pour la conversion d'une tension AC en une tension DC, ledit convertisseur étant compris dans une enceinte délimitant la sous-station ;
    - une traverse de mur pour connecter ledit au moins un convertisseur à des systèmes électriques situés en dehors de l'enceinte;

    ladite sous-station étant **caractérisée en ce qu'**elle comprend au moins un dispositif (20) selon l'une quelconque des revendications précédentes, ledit dispositif étant installé sur un conducteur de courant qui relie ledit au moins un convertisseur à une extrémité de ladite traverse de mur située à l'intérieur de ladite enceinte.

12. Sous-station HVDC selon la revendication précédente, **caractérisée en ce qu'**elle comprend une pluralité de dispositifs selon l'une quelconque des revendications 1 à 10, installés à la suite sur ledit conducteur de courant, au moins deux dispositifs (20) ayant un shunt de mesure de haute précision en commun.

**Patentansprüche**

1. Strommeßvorrichtung (20) zum Messen des Stroms, der in einem Leiter (5) mit hoher Spannung fließt, wobei die Vorrichtung umfaßt:

    - einen Faraday-Sensor (1), umfassend einen optischen Wellenleiter (4) und einen optischen Detektor (7), der mit dem optischen Wellenleiter verbunden ist, wobei der optische Wellenleiter um den Leiter herum montiert ist, wobei der Faraday-Sensor ein erstes digitales Signal ($S_1$) liefert, das repräsentativ ist für den Wert des Stroms ($I_{LS}$) und dessen Wert von einem variablen Koeffizienten (a') abhängt, genannt Faraday-Koeffizient, und

- einen Meß-Shunt (21), der in Reihe mit dem Leiter montiert ist und ein zweites digitales Signal ($S_2$) liefert, das für den Wert des Stroms repräsentativ und eine Funktion eines Verhältnisses ($R_f$) des Shunts ist,

**dadurch gekennzeichnet, dass** die Vorrichtung ferner umfaßt:

- Rechenmittel (23), die an ihrem Eingang die zwei digitalen Signale empfangen und dazu ausgelegt sind, eine erste Komponente DC ($\overline{S}_1$) des ersten digitalen Signals und eine zweite Komponente DC ($\overline{S}_2$) des zweiten digitalen Signals zu extrahieren und den Wert des variablen Koeffizienten ausgehend von der ersten und der zweiten Komponente DC und dem Verhältnis zu berechnen, wobei die Rechenmittel (23) dazu ausgelegt sind, den Strom ausgehend von dem derart berechneten Wert des Faraday-Koeffizienten und dem ersten digitalen Signal zu ermitteln.

2. Vorrichtung nach Anspruch 1, **dadurch gekennzeichnet, dass** die Rechenmittel (23) dazu ausgelegt sind, den Strom zu berechnen ausgehend von der Gleichung:

$$I_{LB} = \frac{1}{2 \cdot k \cdot V} \cdot Arcsin\left(\frac{2\,S_1 - a'}{a'}\right)$$

wobei a' der variable Koefifizient ist, V die Verdet-Konstante des Faraday-Sensors ist, k eine Konstante ist, die vom verwendeten Wellenleiter abhängt, $S_1$ das erste digitale Signal ist, und $I_{LB}$ der Strom ist.

3. Vorrichtung nach Anspruch 1, **dadurch gekennzeichnet, dass** die Rechenmittel (23) dazu ausgelegt sind, den Strom zu berechnen ausgehend von der Gleichung:

$$I_{LB} = \frac{1}{2 \cdot k \cdot V} \cdot \left(\frac{2\,S_1 - a'}{a'}\right),$$

wobei a' der variable Koeffizient ist, V die Verdet-Konstante des Faraday-Sensors ist, k eine Konstante ist, die vom verwendeten Wellenleiter abhängt, $S_1$ das erste digitale Signal ist, und $I_{LB}$ der Strom ist.

4. Vorrichtung nach einem der vorhergehenden Ansprüche, **dadurch gekennzeichnet, dass** die erste Komponente DC ($\overline{S}_1$) des ersten digitalen Signals und die zweite Komponente DC ($\overline{S}_2$) des zweiten digitalen Signals erhalten werden durch digitale Filterung des ersten ($S_1$) und des zweiten ($S_2$) digitalen Signals in einem Frequenzband von 0 bis 0,1 Hz.

5. Vorrichtung nach einem der vorhergehenden Ansprüche, **dadurch gekennzeichnet, dass** das zweite digitale Signal ($S_2$) erhalten wird am Ausgang einer optisch gespeisten Primärkarte (22), welche Primärkarte in einer Hochspannungszone installiert ist, die den Leiter, den Meß-Shunt und den optischen Wellenleiter umfaßt.

6. Vorrichtung nach einem der vorhergehenden Ansprüche, **dadurch gekennzeichnet, dass** der Faraday-Sensor vom Typ Ring-Glas ist.

7. Vorrichtung nach einem der vorhergehenden Ansprüche, **dadurch gekennzeichnet, dass** der Meß-Shunt (21) ein Shunt einer Präzisionsklasse kleiner oder gleich 0,1 ist.

8. Vorrichtung nach einem der vorhergehenden Ansprüche, **dadurch gekennzeichnet, dass** der Shunt aus Manganin hergestellt ist.

9. Vorrichtung nach einem der vorhergehenden Ansprüche, **dadurch gekennzeichnet, dass** der optische Detektor (7) des Faraday-Sensors und die Rechenmittel (23) auf der gleichen elektronischen Karte (24) angebracht sind, welche elektronische Karte auf das Potential der Erde (GND) gebracht und von dem Leiter (5) isoliert ist, und ferner die monochromatische Lichtquelle (2) des Faraday-Sensors umfaßt, um ein mittels eines Polarisators (3) linear polarisiertes Lichtsignal über eine optische Faser (40) an den optischen Wellenleiter (4) zu übertragen, wobei die Verbindung zwischen der elektronischen Karte (24) und der Primärkarte (22) sowie die Verbindung zwischen dem optischen Detektor (7) und dem Wellenleiter (4) mittels optischer Fasern (31, 41) realisiert ist.

10. Vorrichtung nach dem vorhergehenden Anspruch, **dadurch gekennzeichnet, dass** die Isolierung der elektronischen Karte (24) von dem Leiter (5) mittels eines Verbundisolators aus Silikonharz realisiert ist.

11. HVDC-Teilstation, umfassend:

- wenigstens einen Wandler für die Umwandlung einer AC-Spannung in eine DC-Spannung, wobei der Wandler in einem Gehäuse enthalten ist, das die Teilstation begrenzt;
- eine Wanddurchführung, um den wenigstens einen Wandler an elektrische Systeme anzuschließen, die außerhalb des Gehäuses angeordnet sind;

wobei die Teilstation **dadurch gekennzeichnet ist, dass** sie wenigstens eine Vorrichtung (20) nach einem der vorhergehenden Ansprüche umfaßt, wobei die Vorrichtung an einem Stromleiter installiert ist, der den wenigstens einen Wandler mit einem Ende der Wanddurchführung verbindet, das im Inneren des Gehäuses angeordnet ist.

12. HVDC-Teilstation nach dem vorhergehenden Anspruch, **dadurch gekennzeichnet, dass** sie eine Mehrzahl von Vorrichtungen nach einem der Ansprüche 1 bis 10 umfaßt, die in einer Folge an dem Stromleiter installiert sind, wobei wenigstens zwei Vorrichtungen (20) einen gemeinsamen Hochpräzisions-Meß-Shunt haben.

**Claims**

1. Current-measuring device (20) for measuring the current flowing in a high-voltage conductor (5), said device comprising:

- a Faraday sensor (1) comprising an optical waveguide (4) connected to an optical detector (7), said optical waveguide being mounted around said conductor, said Faraday sensor providing a first digital signal ($S_1$) representative of the value of said current ($I_{LB}$) and of which the value depends on a variable coefficient (a'), referred to as a Faraday coefficient;
- a measuring shunt (21) mounted in series on said conductor and providing a second digital signal ($S_2$) representative of the value of said current and as a function of a ratio ($R_f$) of said shunt;

**characterised in that** said device further comprises:

- calculation means (23) receiving as input the two digital signals and adapted to extract a first DC component ($\overline{S}_1$) from said first digital signal and a second DC component ($\overline{S}_2$) from said second digital signal and to calculate the value of said variable coefficient on the basis of said first and of said second DC components and of said ratio, said calculation means (23) being adapted to obtain said current on the basis of the value thus calculated from said Faraday coefficient and from said first digital signal.

2. Device according to claim 1, **characterised in that** the calculation means (23) are adapted to calculate the current on the basis of the equation:

$$I_{LB} = \frac{1}{2.k.V} . Arcsin\left(\frac{2.S_1 - a\prime}{a\prime}\right)$$

where a' is the variable coefficient, $V$ the Verdet constant of said Faraday sensor, k a constant that depends on the waveguide used, $S_1$ said first digital signal and $I_{LB}$ said current.

3. Device according to claim 1, **characterised in that** the calculation means (23) are adapted to calculate the current on the basis of the equation:

$$I_{LB} = \frac{1}{2.k.V} \cdot \left( \frac{2.S_1 - a\prime}{a\prime} \right),$$

where a' is the variable coefficient, $V$ the Verdet constant of said Faraday sensor, k a constant that depends on the waveguide used, $S_1$ said first digital signal and $I_{LB}$ said current.

4. Device according to any preceding claim, **characterised in that** said first DC component ($\overline{S}_1$) of said first digital signal and said second DC component ($\overline{S}_2$) of said second digital signal are obtained by digital filtering of said first ($S_1$) and second ($S_2$) digital signals in a frequency band from 0 to 0.1 Hz.

5. Device according to any preceding claim, **characterised in that** said second digital signal ($S_2$) is obtained as output from an opto-supplied primary board (22), said primary board being installed in a high-voltage zone comprising the conductor, the measuring shunt and the optical waveguide.

6. Device according to any preceding claim, **characterised in that** said Faraday sensor is of the Ring-Glass type.

7. Device according to any preceding claim, **characterised in that** the measuring shunt (21) is a shunt of a precision class less than or equal to 0.1.

8. Device according to any preceding claim, **characterised in that** the shunt is made from manganin.

9. Device according to any preceding claim, **characterised in that** said optical detector (7) of said Faraday sensor and said calculation means (23) are added onto the same electronic board (24), said electronic board being connected to the potential of the ground (GND) and isolated from said conductor (5) and further comprises the monochromatic light source (2) of said Faraday sensor to transmit a linearly polarised light signal by means of a polariser (3) to said optical waveguide (4) via an optical fibre (40), with the connection between said electronic board (24) and a said primary board (22) and the connection between said optical detector (7) and said waveguide (4) being carried out via optical fibres (31,41).

10. Device according to the preceding claim, **characterised in that** the isolation of the electronic board (24) from the conductor (5) is carried out by a composite isolator made of silicone resin.

11. HVDC substation comprising:

- at least one converter for converting an AC voltage into a DC voltage, said converter being comprised in an enclosure delimiting the substation;
- a wall bushing to connect said at least one converter to electrical systems located outside of the enclosure;

said substation being **characterised in that** it comprises at least one device (20) as claimed in any preceding claim, said device being installed on a current conductor that connects said at least one converter to an end of said wall bushing located inside said enclosure.

12. HVDC substation as claimed in the preceding claim, **characterised in that** it comprises a plurality of devices according to any of claims 1 to 10, installed in sequence on said current conductor, at least two devices (20) having a shared high-precision measuring shunt.

FIG.1

FIG.2

FIG.3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2010012300 A1
- FR 9301991

- US 6114846 A

**Littérature non-brevet citée dans la description**

- **D. CHATREFOU.** NCIT's - Modern digital instruments transformers for UHV AC and DC networks. *Conférence on Advances in Power System Control, Operation and Management,* 29 Juillet 2010, 1-6